# EUROPÄISCHE PATENTSCHRIFT

(11) **EP 1 512 183 B1**
(45) Veröffentlichungstag und Bekanntmachung des Hinweises auf die Patenterteilung: **26.04.2017**
(21) Anmeldenummer: 03727478.4
(22) Anmeldetag: 14.05.2003
(51) Int. Cl.: H01L 41/083, H01L 41/047

(54) **MONOLITHISCHER VIELSCHICHTAKTOR AUS EINEM PIEZOKERAMISCHEN ODER ELEKTROSTRIKTIVEN MATERIAL SOWIE HERSTELLUNGSVERFAHREN UND ELEKTRISCHE AUSSENKONTAKTIERUNG**
METHOD FOR THE PRODUCTION OF A MONOLITHIC MULTILAYER ACTUATOR, MONOLITHIC MULTILAYER ACTUATOR MADE OF A PIEZOCERAMIC OR ELECTROSTRICTIVE MATERIAL, AND EXTERNAL ELECTRICAL CONTACT FOR A MONOLITHIC MULTILAYER ACTUATOR
PROCEDE DE PRODUCTION D'UN ACTIONNEUR MULTICOUCHE MONOLITHIQUE, ACTIONNEUR MULTICOUCHE MONOLITHIQUE CONSTITUE D'UN MATERIAU PIEZOCERAMIQUE OU ELECTROSTRICTIF ET METALLISATION EXTERIEURE ELECTRIQUE POUR UN ACTIONNEUR MULTICOUCHE MONOLITHIQUE

(30) Priorität: 07.06.2002 DE 10225405; 30.07.2002 DE 10234787
(43) Veröffentlichungstag der Anmeldung: 09.03.2005
(73) Patentinhaber: PI Ceramic GmbH, 07589 Lederhose (DE)
(72) Erfinder: HEINZMANN, Astrid, 07549 Gera (DE); HENNIG, Eberhard, 07646 Stadtroda (DE); KOPSCH, Daniel, 04886 Grosstreben-Zwethau (DE); PERTSCH, Patrick, 07629 Hermsdorf (DE); RICHTER, Stefan, 07927 Hirschberg (DE); WEHRSDORFER, Eike, 07607 Eisenberg (DE)
(74) Vertreter: Kruspig, Volkmar
(86) Internationale Anmeldenummer: PCT/EP2003/005051
(87) Internationale Veröffentlichungsnummer: WO 2003/105246

(56) Entgegenhaltungen:
- EP-A- 0 479 328
- EP-A- 0 844 678
- EP-A- 1 204 152
- DE-A- 3 940 619

## Beschreibung

Die Erfindung betrifft ein Verfahren zur Herstellung eines monolithischen Vielschichtaktors aus einem piezokeramischen oder elektrostriktiven Material, wobei der Aktor als Stapelanordnung in quasi mechanischer Reihenschaltung einer Vielzahl von Piezoplatten durch Sintern durch Grünfolien ausgebildet wird, vorhandene Innenelektroden im Plattenstapel zu gegenüberliegenden Außenflächen des Stapels geführt und dort mittels Grundmetallisierung sowie Außenkontaktierung jeweiliger Elektrodengruppen parallel verschalten sind gemäß Oberbegriff des Patentanspruches 1 oder 3 oder 4. Weiterhin betrifft die Erfindung einen monolithischen Vielschichtaktor aus einem piezokeramischen oder elektrostriktiven Material, wobei der Aktor eine Stapelanordnung von Piezoplatten ist, welche über innere Elektroden, eine gemeinsame Grundmetallisierung sowie Außenkontaktierung verfügt gemäß Patentanspruch 11.

Piezokeramische Aktoren sind elektro-mechanische Wandler, bei denen der reziproke piezoelektrische Effekt ausgenutzt wird. Legt man an eine piezokeramische Platte mit Elektroden auf ihren Hauptflächen, die in Richtung der Plattendicke polarisiert ist, ein elektrisches Feld an, so kommt es zu einer Formänderung. Konkret vollzieht sich eine Ausdehnung in Richtung der Plattendicke, wenn das angelegte elektrische Feld parallel zum ursprünglichen Polungsfeld gerichtet ist. Gleichzeitig kommt es senkrecht zur Feldrichtung zu einer Kontraktion.

Durch Übereinanderstapeln einer Vielzahl solcher Platten im Sinne einer mechanischen Reihenschaltung und elektrischer Parallelschaltung der Platten, können so die Deformationen der einzelnen Platten addiert werden. Bei einem Dehnvermögen von etwa 0, 1 - 0, 2 % bei Feldstärken von 2 kV/mm lassen sich so Auslenkungen von etwa 1 - 2 µm pro mm Bauhöhe realisieren.

Bei monolithischen Vielschichtaktoren erfolgt das Stapeln bereits im grünen Zustand und die endgültige Verbindung wird durch Sintern vorgenommen. Hierbei werden bis zu einigen hundert piezokeramische Grünfolien alternierend mit metallischen Innenelektroden gestapelt, verpresst und zu einem monolithischen Körper gesintert. Die Innenelektroden werden dabei wechselseitig auf die gegenüberliegenden Flächen bis zur jeweiligen Oberfläche herausgezogen und dort im Regelfall durch eine Grundmetallisierung in Dick-oder Dünnschichtausführung miteinander verbunden.

Dieses Design wird auch als Ausführung mit Interdigitalelektroden bezeichnet. Ein piezoelektrischer Aktor umfasst also piezokeramische Schichten und Gruppen von inneren Elektroden, die jeweils auf gegenüberliegende Flächen bis an die Oberfläche führen. Eine Grundmetallisierung dient der Parallelschaltung der jeweiligen Elektrodengruppe. Weiterhin sind inaktive Bereiche vorhanden, die weder beim Polarisieren noch beim üblichen Betrieb des Aktors piezoelektrisch gedehnt werden.

Diese inaktiven Bereiche in den Multilayaktoren mit interdigitalen Elektroden stellen ein kritisches Moment für die Herstellbarkeit und Zuverlässigkeit derartige Produkte bzw. unter Rückgriff auf solche Produkte realisierter Finalerzeugnisse dar. Aufgrund der hohen Zug-Spannungskonzentrationen in den inaktiven Bereichen und in Verbindung mit der geringen Zugfestigkeit der piezokeramischen Werkstoffe kommt es bereits bei der Polarisation, die mit remanenten Dehnungen von bis zu 0,3 % verbunden ist oder aber später beim Betrieb zu unterwünschten Rissbildungen.

Die vorgenannte unkontrollierte Rissbildung hat verschiedenste Ausfallmechanismen der Aktoren zur Folge. Setzt sich das Risswachstum in das Innere des Aktors fort, kann dies einerseits zur mechanischen Zerstörung des Aktors führen, andererseits können hierdurch bedingt innere Überschläge auftreten, wenn der Riss von einer Elektrodenschicht zur anderen wächst. Mit einer geeigneten Prozessführung kann das Risswachstum in das Innere des Aktors begrenzt werden. Nicht verhindert werden kann allerdings das Risswachstum in Richtung der Aktoroberfläche. Erreicht der Riss die Aktoroberfläche, führt dies zur Unterbrechung der auf der Oberfläche aufgebrachten Grundmetallisierung. Hierdurch werden Teilbereiche des Aktors galvanisch von der Spannungszuführung abgetrennt und infolge dessen treten elektrische Überschläge an den Unterbrechungen der Grundmetallisierung auf. Diese Überschläge wiederum sind der Grund, die letztendlich zum Totalausfall des Aktors führen.

Zur Überwindung der zitierten Rissproblematik sind eine Vielzahl von Lösungen bekannt, die entweder die Verhinderung der Rissbildung oder bei nicht zu vermeidenden unkontrollierten Rissbildungen ein Reduzieren oder Eliminieren von Überschlägen an der Grundmetallisierung auf die Oberfläche durch zusätzliche Maßnahmen zum Ziel haben.

Die JP 58-196077 offenbart einen Multilayeraktor und ein Verfahren zu seiner Herstellung, bei dem entlang der Aktorachse eine Vielzahl von Schlitzen mit einer Tiefe von etwa 0,5 mm parallel zu den inneren Elektroden in den Aktor eingebracht wird. Diese Schlitze führen ähnlich wie die aus anderen Bereichen der Technik bekannten Dehnungsfugen zum Abbau von Spannungskonzentrationen und verhindern somit eine unkontrollierte Rissbildung oder ein Wachstum des Risses im Aktorgefüge.
Nachteilig ist jedoch die Tatsache, dass durch diese Schlitze auch der tragende Querschnitt des Aktors verringert ist, was gleichzeitig die Druckbelastbarkeit des Aktors im Einsatz verringert. Beim angegebenen Beispiel reduziert sich der tragende Querschnitt des Aktors auf 3x3 mm² bei einem Gesamtquerschnitt von 4x4 mm². Das zitierte Verfahren, bei dem die Schlitze durch thermisch zersetzbare Schichten auf den grünen Keramikfolien beim Sintern gebildet werden, weist auch auf weitere Probleme hin, die beim Sintern zu einem ebenfalls unkontrollierten Risswachstum führen können und die nur durch spezielle aufwendige Ausgestaltungen der inneren Elektroden verhinderbar sind. Als Ursache für die Rissbildung beim Sintern wird dort die inhomogene Verdichtung des grünen Stapels beim Verpressen erwähnt.

Bei der EP 0 844 678 A1 wird ebenfalls auf die Problematik der Rissbildung und deren Folgen eingegangen, wenn durch die Risse die Grundmetallisierung zerstört wird.
Zur Vermeidung von Schädigungen des Aktors wird dort vorgeschlagen, zwischen der Spannungszuleitung und der Grundmetallisierung eine dreidimensional strukturierte elektrisch leitfähige Elektrode einzufügen, die nur partiell mit der Grundmetallisierung verbunden ist und die zwischen den Kontaktstellen dehnbar ausgebildet wird. Die praktische Realisierung einen solchen dreidimensionalen Struktur erfordert aber einen sehr hohen Aufwand, da die partiellen Kontaktstellen einen definierten Abstand in der Größenordnung des Abstandes der inneren Elektroden haben müssen.

Bei der Anordnung für eine sichere Kontaktierung von piezoelektrischen Aktoren nach DE 196 46 676 C1 wird an der als Kontaktstreifen ausgebildeten Grundmetallisierung eine elektrische leitende Kontaktfahne mit hoher Rissfestigkeit so angebracht, dass ein überstehender Bereich der Kontaktfahne verbleibt. Dabei muss der überstehende Bereich der Kontaktfahne so groß ausgebildet werden, dass auftretende Risse die Kontaktfahne nicht vollständig durchtrennen. Eine solche Anordnung ist aber sehr empfindlich beim Handling. Bekanntlich besitzt die Grundmetallisierung auf der Oberfläche des piezokeramischen Aktors nur eine sehr geringe Schälfestigkeit. Bereits geringe Schälkräfte führen zur Ablösung der Grundmetallisierung von der Aktoroberfläche und somit zum teilweisen oder vollständigen Verlust der elektrischen Kontaktierung zu den Innenelektroden.

Eine weitere Variante, das Risswachstum vom Aktorkörper zur Oberflächenelektrode zu entkoppeln ist in der DE 100 17 331 C1 offenbart. Dort wird vorgeschlagen, zwischen Grundmetallisierung und Außenelektrode eine elektrisch leitende Pulverschicht einzubringen. Eine solche Anordnung verhindert zwar den Rissfortschritt, ist aber technisch nur unter erheblichen Aufwendungen zuverlässig zu realisieren, da der elektrische Kontakt der Pulverteilchen mit der inneren und äußeren Elektrode und untereinander nur über Berührung erfolgt, was einen Kontaktmindestdruck erfordert. Weiterhin sind berührende Kontakte sehr stark gegenüber Korrosionserscheinungen anfällig.

Die WO 00-79607 A1 und WO 00-63980 A1 offenbaren Lösungen, die darauf abzielen, jede der an die Oberfläche herausgeführten Elektroden einzeln zu kontaktieren. Bei Elektrodenabständen von 50 - 250 µm ist dies jedoch nicht kostengünstig umsetzbar. In EP 1 204 152 A2 werden ebenfalls Außenelektroden an piezokeramischen Vielschichtaktoren offenbart.

Aus dem Vorgenannten ist es daher Aufgabe der Erfindung, ein Verfahren zur Herstellung eines monolithischen Vielschichtaktors aus einem piezokeramischen oder elektrostriktiven Material anzugeben, mit dessen Hilfe es gelingt einen Aktor mit hoher Zuverlässigkeit und Langzeitstabilität zu schaffen, welcher darüber hinaus in der Lage ist, hohen Druckkräften bei geringem Aktorquerschnitt Stand zu halten. Weiterhin ist es Aufgabe der Erfindung einen monolithischen Vielschichtaktor aus einem piezokeramischen oder elektrostriktiven Material zu schaffen, wobei dieser neuartige Aktor mit Hilfe eines erfindungsgemäßen Verfahrens hergestellt ist.

Die verfahrensseitige Lösung der Aufgabe der Erfindung erfolgt mit einer Lehre in der Definition nach Patentanspruch 1 oder 3 oder 4.

Bezüglich des Vielschichtaktors selbst sei auf die Merkmalskombination nach Anspruch 11 verwiesen.

Die Unteransprüche stellen jeweils mindestens zweckmäßige Ausgestaltungen und Weiterbildungen des Erfindungsgegenstandes dar.

Der Grundgedanke der Erfindung liegt unter Berücksichtigung der in den Ansprüchen konkretisierten Lehre darin, entlang der Aktorachse und im Wesentlichen parallel zu den Innenelektroden im Bereich der mindestens zwei gegenüberliegenden Außenflächen, zu denen die inneren Elektroden wechselseitig herausgeführt werden, Mikrostörungen im Aktorgefüge so einzubauen, dass diese als quasi am vorbekannten Ort stehende Rissquelle wirken, wobei das Risswachstum kontrollierbar ist. Die Außenkontaktierung wird durch eine in Ansicht bekannter Weise mittels Dick- oder Dünnschichttechnologie realisierte Grundmetallisierung gebildet, wobei die Elektrodenbereiche zwischen den Orten der Mikrostörungen und möglicher, nach außen reichende Risse durch eine dehnungsresistente, zweite Außenelektrode miteinander verbunden werden.

Durch den gezielten Einbau von Gefügeschwächungen, die als potentielle Rissquelle wirken, kann eine weitere Rissbildung gezielt gesteuert werden. Bei einem Abstand der Rissquellen im Bereich von ein 1 - 4, bevorzugt 2 - 3 mm werden die inneren mechanischen Spannungen so abgebaut, dass in den Abschnitten zwischen den Rissquellen auch bei zyklischer Belastung von weit über 10⁹ Zyklen keine weitere Rissbildung beobachtet wird.

Von erfindungswesentlicher Bedeutung ist, dass die gezielt eingebrachten Rissquellen im Aktorgefüge selbst noch keinen Riss im eigentlichen Sinne darstellen. Der gezielt gesteuerte Riss entsteht erst nach der Polarisation des Aktors und zwar nur in dem Umfang, wie beim Polarisieren remanente Dehnungen gegeben sind. Dadurch, dass das Gefüge beim Schritt des Aufbringens der Grundmetallisierung noch geschlossen ist, dringt auch keine Metallisierungsmasse in das piezokeramische Material ein, was zu einer wesentlichen Qualitätsverbesserung derartig realisierter Aktoren führt.

Die Rissquellen verhindern örtlich begrenzt das Zusammensintern der Grünfolien mit dem Ergebnis einer dezidierten Delaminierung.

Zum Erreichen dieses Delaminierens besteht die Möglichkeit im Bereich gewünschter Rissquellen beim Stapelaufbau einer Schicht oder Mengen eines organischen Binders aufzubringen, welche einen Volumenanteil von bis zu 50% organischer Partikel mit einem Durchmesser ≤ 200 µm enthält, die beim Sinterprozess nahezu vollständig ausbrennen.

Diese vorgeschriebene Schicht kann durch Siebdruck aufgebracht werden und wird vor dem Sintern durch Pressen derart verdichtet, dass die in den Grünfolien eingebetteten Keramikpartikel sich nur teilweise oder nicht berühren, um gezielt ein Zusammensintern ganz oder teilweise zu unterbinden.

Alternativ besteht die Möglichkeit die Rissquellen durch eine Menge anorganischer Füllpartikel mit einem Durchmesser von ≤ 1 µm auszubilden, wobei diese Füllpartikel nicht mit den piezoelektrischen Werkstoff des Stapels reagieren. Die Füllpartikel werden in an sich bekannter Weise dem Binder zugesetzt und stellen ein Bestandteil des Letzteren dar.

Bei einer weiteren Ausführungsform besteht die Möglichkeit die Rissquellen durch Kerbanrisse zu induzieren, wobei diese Kerbanrisse entweder im grünen oder gesinterten Zustand erzeugt werden, ohne jedoch die tragende Querschnittsfläche des Aktorstapels zu reduzieren.

Dadurch, dass die Lage potentieller Risse durch das definierte Einbringen der Rissquellen bekannt ist, besteht die Möglichkeit in Kenntnis dieser Position oder Lage die Außenkontaktierung auszugestalten. Erfindungsgemäß besteht die Außenkontaktierung jeweils aus einer flächigen Biegegelenkelektrode, welche mit der Grundmetallisierung mindestens im Bereich zwischen den Rissquellen elektrisch in Verbindung steht.

Konkret kann die flächige Biegeelektrode einen aufgelöteten Kupfer/Berylliumstreifen umfassen, wobei der Streifen jeweils offene Ellipsenform aufweisende Abschnitte umfasst. Die Hauptachse der jeweiligen offenen Ellipsen verläuft im Bereich der jeweiligen Rissquelle.

Bei einer Alternative ist die Biegeelektrode als Mäander- oder Doppelmäanderelektrode ausgeführt, wobei die Verbindungsabschnitte des Mäanders jeweils im Bereich der Rissquellen verlaufen.

Auf den Biegeelektroden befinden sich Lötabschnitte oder Lötpunkte zur Kontaktierung mit der Grundmetallisierung und/oder zur weiteren Verdrahtung.

Die Stapelanordnung, welche den Aktor bildet, umfasst elektrodenfreie passive Endschichten als Kraftkoppelflächen.
Der Abstand der ersten Rissquelle zur passiven Endschicht ist gleich dem ganzen oder halben Abstand der übrigen, über die Längsachse verteilten Rissquellen gewählt.

Der erfindungsgemäße Vielschichtaktor aus einem piezokeramischen oder elektrostriktiven Material ist nach einem erfindungsgemäßen Verfahren hergestellt.

Der erfindungsgemäße Vielschichtaktor aus einem piezokeramischen oder elektrostriktiven Material weist entlang der Stapellängsachse im Wesentlichen parallel zu den Innenelektroden delaminierende Rissquellen auf, wobei dort die Zugfestigkeit im Vergleich zum umgebenden Gefüge bei gleichzeitigem Erhalt der Druckfestigkeit des Stapels verringert ist.
Zusammenfassend liegt der Lösungsansatz der Erfindung darin, gezielt in dem Aktormaterial für Gefügeschwächungen Sorge zu tragen, so dass an dann bekannten Stellen Risse entstehen und zwar erstmals dann, wenn der Aktor einer Polarisation unterworfen wird. Dadurch, dass die Lage der gezielten erzeugten Risse bekannt ist, kann durch eine entsprechende dehnbare Elektrodenkonfiguration dafür gesorgt werden, dass eine elektrische Kontaktierung in jedem Fall sicher stattfindet bzw. erhalten bleibt.

Bekanntermaßen findet ein Risswachstum im wesentlichen senkrecht zur Aktorlängsachse und zwar in beiden Richtungen, das heißt sowohl ins Innere des Aktors hinein als auch nach außen zur Grundmetallisierung hin statt. Dies ist üblicherweise ein negativer Effekt. Da aber erfindungsgemäß die Außenkontaktierung aufgrund der bekannten Lage der Risse modifizierbar ist, können potentielle Risse von vornherein überbrückt werden und es werden die im Stand der

Technik gegeben Ausfallerscheinungen reduziert.

Gemäß dem Stand der Technik ist es notwendig eine möglichst hohe Anzahl von Kerben oder Schlitze, insbesondere auch im Endbereich des Aktors einzubringen, da die Spannungsverhältnisse im Aktor selbst nicht bekannt sind. Jeder der einzubringenden Kerben oder Schlitze führt aber zu einer verringerten mechanischen Stabilität und damit Belastbarkeit des Aktors selbst.

Bei der vorliegenden Erfindung werden zwar gezielte Gefügeveränderungen eingebaut, die potentiell auch einen Riss nach sich ziehen können, wenn entsprechende Spannungen auftreten, dies ist aber nicht vergleichbar mit einer von vornherein unabwendbaren mechanischen Schwächung des Gefüges durch einen Schlitz, der beispielsweise durch Fräsen, Einkerben oder ähnlich erzeugt wird. Die aus dem Stand der Technik bekannten Schlitze entsprechen einem Materialabtrag. Der materialabgetragene Bereich des Aktors leistet aber augenscheinlich keinen Festigkeitsbeitrag mehr.

In dem Falle, wenn in die Binderschicht größere, ein zusammensintern verhindernde Partikel eingebracht werden verbleibt der vorteilhafte Effekt, dass eine Tragfähigkeit-oder Kraftübernahme durch diese Partikel gewährleistet ist, die einen nicht unwesentlichen Beitrag zur Gesamtstabilität leisten. Hierbei ist wesentlich, dass beim Aktor selbst nur Druckkräfte in Richtung der Aktorlängsachse interessieren.

Die Kerbanrisse nach der Erfindung sind keinesfalls vergleichbar mit den makroskopischen Kerben nach dem Stand der Technik. Hier handelt es sich vielmehr um im Mikrometerbereich liegende Eindrücke, die quasi mit dem Eindrücken eines Probekörpers, wie aus der Materialprüfung bekannt, vergleichbar sind.

Wie oben erläutert, ist dafür Sorge zu tragen, dass bei dem Übereinanderschichten der einzelnen Folien zwischen ausgewählten Bereichen von Folien oder Schichten ein Delaminationseffekt eintritt. Dieses bedeutet, dass dort eine Zugbeanspruchung nicht möglich ist, jedoch die benachbarten Folien so dicht aufeinanderliegen, dass eine Druckkraftübertragung möglich wird und zwar im Gegensatz zu den Bereichen mit Schlitz oder Kerbe nach dem Stand der Technik.

Bei einer Ausführungsform kann der Abstand zwischen zwei wechselseitig herausgeführten Elektroden in einem oberen und/oder unteren Endbereich des Aktors doppelt so groß sein wie zu den darunterliegenden, benachbarten Elektroden. Aufgrund des größeren Abstandes ist ein Hineinwandern eines durch das veränderte Mikrogefüge bedingten Risses in den Elektrodenbereich und damit ein Unterbrechen der Elektrode im Inneren des Aktors verhinderbar. Der Nachteil einer dort vorliegenden anderen Feldstärke wird auf jeden Fall vom Vorteil des aktiven Leistungsbeitrages des Aktors in diesem Bereich aufgehoben.

Der Erfindung soll nachstehend anhand von Ausführungsbeispielen sowie unter Zuhilfenahme von Figuren näher erläutert werden.

Hierbei zeigen:
- Figur 1: eine prinzipielle Stapelaktoranordnung nach dem Stand der Technik;
- Figur 2a: ein erfindungsgemäßer Aktor vor der Polarisation;
- Figur 2b: ein Aktor nach der Polarisation;
- Figur 3a: eine Ausführungsform der Außenkontaktierung mit Mäanderelektrode;
- Figur 3b: eine Ausführungsform der Außenelektrode mit offenen Ellipsen;
- Figur 4a: eine Schnittdarstellung eines erfindungsgemäßen Aktors mit verändertem Abstand gegenüberliegender Innenelektroden in vorgegebenen Endbereichen und
- Figur 4b: eine Seitenansicht eines Teiles eines erfindungsgemäßen Aktors mit erkennbarer Elektrodenanordnung in Form von Biegegelenken, ausgebildet als offene, durch Stege verbundene Ellipsen.

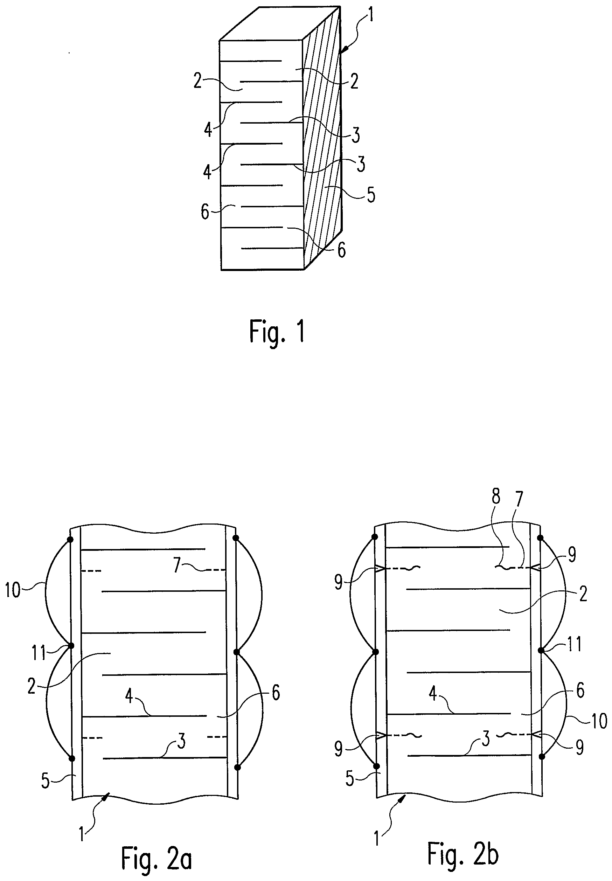

Die in der Figur 1 gezeigte Ausführungsform eines Vielschichtaktors nach dem Stand der Technik geht von einer Interdigitalenelektrodenanordnung aus. Mit dem Bezugszeichen 1 ist der Aktor selbst, mit dem Bezugszeichen 2 sind die piezokeramischen Schichten benannt. Die inneren Elektroden 3 und 4 sind jeweils auf die gegenüberliegenden Flächen bis an die Oberfläche herausgeführt. Die Grundmetallisierung 5 dient der Parallelschaltung der jeweiligen Elekrodengruppe. Ein inaktiver Bereich 6 des Aktors 1 wird weder beim Polarisieren noch beim Betrieb des Aktors 1 piezoelektrisch gedehnt und bildet ein Spannungsrisspotential.

Der erfindungsgemäße Aktor gemäß dem Ausführungsbeispiel nach den Figuren 2a und 2b umfasst piezokeramische Schichten 2 mit einer Dicke im Bereich von 20 - 100 µm. Diese Schichten sind durch innere Elektroden 3 und 4, vorzugsweise bestehen aus einer AgPd-Legierung miteinander verbunden, die wechselseitig auf gegenüberliegende Oberflächen herausgeführt sind.

Die herausgezogene Elektroden 3,4 werden über eine Grundmetallisierung 5, die auf den Seitenoberflächen aufgebracht wird, miteinander verbunden, so dass eine elektrische Parallelschaltung der einzelnen piezoelektrischen Schichten resultiert.

Im Bereich 6, der nicht bis zur Oberfläche herausgezogenen Elektroden 3, 4 entstehen aufgrund der inhomogenen elektrischen Feldverläufe in bekannter Weise bei der Polarisation oder beim Betrieb des Aktors mechanische Spannungskonzentrationen, insbesondere Zugspannungen, die letztendlich Ursache für eine unerwünschte, unkontrollierte Rissbildung sind.

Durch den gezielten Einbau von Gefügeschwächungen, die als Rissquelle 7 wirken, kann die Rissbildung gesteuert werden.

Bei einem Abstand der Rissquellen 7 im Bereich von 1 - 4 mm, bevorzugt 2 - 3 mm können die inneren mechanischen Spannungen so abgebaut werden, dass in den Abschnitten zwischen den Rissquellen, auch bei Belastungen von weit über 10⁹ Zyklen keine weitere Rissbildung beobachtet wird.

Figur 2b zeigt den erfindungsgemäßen Aktor nach der Polarisation. Hier ist die Entspannungswirkung schematisch dargestellt. Von der Rissquelle 7 geht dabei einerseits ein gezieltes Risswachstum 8 in das Innere des Aktors aus, welches durch eine geeignete energiesenkende Gefügeausbildung über Vorgabe von Korngrößen und Porosität von selbst gestoppt oder unterbrochen wird.

Andererseits ergibt sich aber auch ein Risswachstum in die Grundmetallisierung an der Stelle 9 hinein, welches im ungünstigsten Fall zur Durchtrennung der Grundmetallisierungsschicht 5 führt.

Beim gezeigten Ausführungsbeispiel erfolgt die elektrische Verbindung der einzelnen Bereiche durch einen bogenförmig verlegten Draht 10, der punktuell über einen Lötpunkt 11 mit der Grundmetallisierung verbunden ist.

Die vorstehend erwähnten Rissquellen sind auf verschiedene Weise in den Aktor implementierbar. Grundsätzlich gilt es, an vorbestimmten Stellen ein Zusammensintern der aufeinandergestapelten und verpressten Grünfolien ganz oder partiell zu verhindern, so dass an diesen Stellen die Zugfestigkeit im Vergleich zum umgebenden Gefüge verringerbar ist. Vorstehendes wird dadurch erreicht, dass in den vorgegebenen Bereichen beim Aufbau der Stapel eine Schicht eines organisches Binders durch Siebdruck aufgetragen wird, die mit einem Volumenanteil von bis zu 50% mit organischen Partikeln mit einen Durchmesser < 200 µm, die beim Sinterprozess vollständig ausbrennen, gefüllt ist.
Diese Schicht wird in den weiteren Verfahrens- oder Verarbeitungsstufen beim Verpressen auf eine Dicke < 1 um zusammengepresst und sorgt dafür, dass die in den Grünfolien eingebetteten Keramikkörper sich nicht oder nur partiell berühren, so dass beim Sintern der Materialtransport von Korn zu Korn ganz oder teilweise verhindert ist.

Eine alternative Möglichkeit besteht darin, dass anstelle organischer Füllpartikel anorganische Partikel mit einem Durchmesser < 1 µm, die nicht mit dem piezoelektrischen Werkstoff reagieren, wie z. B. ZrO₂ oder Pulver eines gesinterten PZT-Werkstoffes mit einer im wesentlichen gleichen Zusammensetzung wie der Aktorwerkstoff dem Binder zugesetzt werden.
Auch können Rissquellen dadurch erzeugt werden, indem entweder im grünen oder im gesinterten Zustand Mikro-Kerbanrisse ausgeführt werden.

Der oben beschriebene Abbau der inneren mechanischen Spannungen durch eine gezielte Risseinbringung in den Aktor besitzt gegenüber den bekannten Lösungen wesentliche Vorteile. So wird z. B. der belastbare Querschnitt des Aktors nur unwesentlich verringert, da die gezielt erzeugten Rissflächen bei Einwirkung einer Druckkraft in Richtung der Aktorachse aufeinandergepresst werden und somit zum tragenden Querschnitt beitragen.
Ein weiterer Vorteil besteht darin, dass sich der Riss frühestens beim Polarisieren öffnet und somit beim Aufbringen der Grundmetallisierung keine Metallpartikel in das Innere des Aktors gelangen können. Hierdurch ergibt sich eine wesentlich verbessere Qualität entsprechend gestalteter Aktoren im Vergleich zum Stand der Technik.
Ein Vorteil besteht auch darin, dass für eine sichere und langzeitstabile elektrische Kontaktierung des Aktors eine einfache, dehnungsresistente Außenelektrode realisierbar ist, die nur punktuell mit der Grundmetallisierung zwischen den Entspannungsrissen zu verbinden ist.

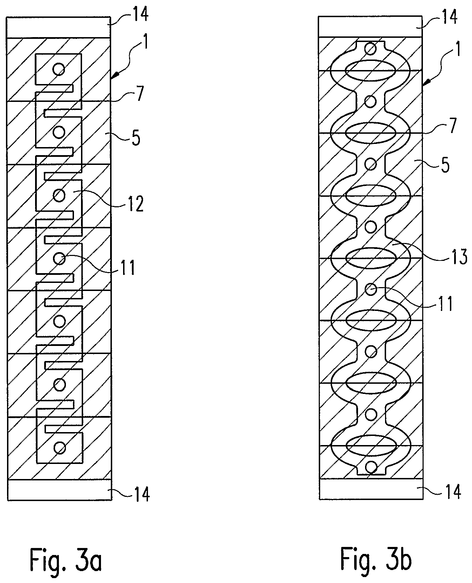

Eine Ausgestaltung einer dehnungsresistenten bzw. elastischen Außenelektrode 12 in Schlitz-oder Mäanderform zeigt Figur 3a. Dort sind auch passive Endschichten 14 ohne innere Elektroden gezeigt, die eine Kraftkoppelfläche bilden. Diese Endschichten 14 können z. B. aus einen monolithischen Isolationsmaterial bestehen und dienen der Aufnahme von verschiedenen Koppelelementen.
Eine ebenso mit passiven Endschichten 14 versehene Ausführungsform des Aktors zeigt Figur 3b.

Dort ist eine Festkörpergelenk umfassende Außenelektrode in Form von offenen Ellipsen 13 vorhanden. Die Hauptachse der jeweiligen offenen Ellipse verläuft im wesentlichen im Bereich erwarteter Risse. Die einzelnen Ellipsen weisen Stege 15 auf, die der elektrischen Kontaktierung der Ellipsen 13 untereinander dienen. Im Bereich der Stege 15 ist jeweils ein Lötpunkt 11 ausgebildet.

Gemäß der Ausführungsform nach Figur 3 ist der Abstand vom ersten Entspannungsriss 7 zur passiven Endschicht 14 gleich dem Abstand der Entspannungsrisse untereinander gewählt. Bei der zweiten Ausführungsform nach Figur 3b beträgt der Abstand des ersten Entspannungsrisses 7 zur passiven Endschicht 14 gleich dem halben Abstand der übrigen Spannungsrisse untereinander.

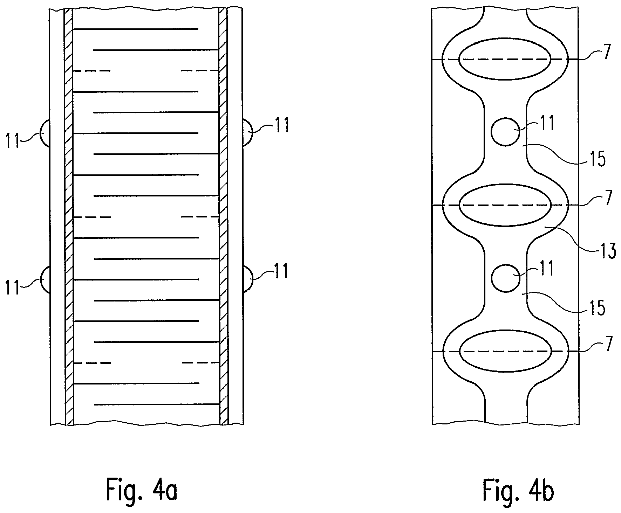

Die Figur 4a offenbart einen in bestimmten Abschnitten des Aktors vorhandenen größeren Abstand der Innenelektroden 3 und 4. Dieser doppelte Abstand im Vergleich zu benachbarten Innenelektroden reduziert die Gefahr, dass ein dazwischen befindlicher Riss 7 zu den Innenelektroden wandert und deren Kontaktierung hin zur Grundmetallisierung bzw. entsprechende elektrische Verbindung unterbricht.

Die in den Figuren 3a und 3b schematisch gezeigte flächige Gestaltung der, z. B. aus Kupfer-Berylliummaterial bestehenden Außenelektrode ist nur beispielhaft zu verstehen. Grundsätzlich ist jede flächige Außenelektrodenform geeignet, die in lateraler Richtung zerstörungsfrei Dehnungs- bzw. Spannungskräfte aufnehmen kann.

### Bezugszeichenliste

- 1: Aktor
- 2: piezokeramische Schicht
- 3,4: innere Elektroden
- 5: Grundmetallisierung
- 6: inaktiver Bereich des Aktors
- 7: Mikrogefügeänderung
- 8: durch Polarisation ausgelöster gezielter Mikroriss
- 9: Unterbrechung der Grundmetallisierung
- 10: bogenförmig verlegter Draht
- 11: Lötpunkt
- 12: mäanderförmige Außenelektrode
- 13: Ellipse einer entsprechend ausgebildeten Außenelektrode
- 14: Endbereiche der Aktors, bevorzugt als monolithische Isolationsschicht ausgeführt
- 15: Verbindungsstege der Ellipsenform - Außenkontaktierung

## Patentansprüche

1. Verfahren zur Herstellung eines monolithischen Vielschichtaktors (1) aus einem piezokeramischen oder elektrostriktiven Material, wobei der Aktor als Stapelanordnung in quasi mechanischer Reihenschaltung einer Vielzahl von Piezoplatten (2) durch Sintern von Grünfolien ausgebildet wird, vorhandene Innenelektroden (3;4) im Plattenstapel zu gegenüberliegenden Aussenflächen des Stapels geführt und dort mittels Grundmetallisierung (5) sowie Aussenkontaktierung (12) jeweiliger Elektrodengruppen parallel verschalten sind,
**dadurch gekennzeichnet, dass**
entlang der Stapellängsachse im wesentlichen parallel zu den Innenelektroden (3;4), von diesen beabstandet, im Bereich der mindestens zwei gegenüberliegenden Aussenflächen, zu denen die Innenelektroden (3;4) herausgeführt sind, gezielt Gefügeschwächungen, die als Rissquelle (7) wirken, im Aktorgefüge mit einem Abstand im Bereich von 1 - 4 mm eingebaut werden, und weiterhin die Grundmetallisierung (5) und/oder die Aussenkontaktierung (12) mindestens im Bereich der Rissquellen (7) im Aktorgefüge dehnungsresistent oder elastisch ausgebildet ist, wobei die Rissquellen (7) örtlich begrenzt ein Zusammensintern der Grünfolien verhindern und im Bereich der Rissquellen (7) beim Stapelaufbau eine Schicht oder Menge eines organischen Binders aufgebracht wird, welche einen Volumenanteil von bis zu 50 % organischer Partikel mit einem Durchmesser ≤ 200 nm enthält, die beim Sinterprozess nahezu vollständig ausbrennen.

2. Verfahren nach Anspruch 1,
**dadurch gekennzeichnet, dass**
die Schicht durch Siebdruck aufgebracht wird, wobei diese Schicht vor dem Sintern durch Pressen derart verdichtet wird, dass die in den Grünfolien eingebetteten Keramikpartikel sich nur teilweise oder nicht berühren, um gezielt ein Zusammensintern ganz oder teilweise zu unterbinden.

3. Verfahren zur Herstellung eines monolithischen Vielschichtaktors (1) aus einem piezokeramischen oder elektrostriktiven Material, wobei der Aktor als Stapelanordnung in quasi mechanischer Reihenschaltung einer Vielzahl von Piezoplatten (2) durch Sintern von Grünfolien ausgebildet wird, vorhandene Innenelektroden (3;4) im Plattenstapel zu gegenüberliegenden Aussenflächen des Stapels geführt und dort mittels Grundmetallisierung (5) sowie Aussenkontaktierung (12) jeweiliger Elektrodengruppen parallel verschalten sind,
**dadurch gekennzeichnet, dass**
entlang der Stapellängsachse im wesentlichen parallel zu den Innenelektroden (3;4), von diesen beabstandet, im Bereich der mindestens zwei gegenüberliegenden Aussenflächen, zu denen die Innenelektroden (3;4) herausgeführt sind, gezielt Gefügeschwächungen, die als Rissquelle (7) wirken, im Aktorgefüge mit einem Abstand im Bereich von 1 - 4 mm eingebaut werden, und weiterhin die Grundmetallisierung (5) und/oder die Aussenkontaktierung (12) mindestens im Bereich der Rissquellen (7) im Aktorgefüge dehnungsresistent oder elastisch ausgebildet ist, wobei
die Rissquellen (7) örtlich begrenzt ein Zusammensintern der Grünfolien verhindern und
die Rissquellen (7) durch eine Menge anorganischer Füllpartikel mit einem Durchmesser von ≤ 1 µm, welche nicht mit dem piezoelektrischen Werkstoff des Stapels reagieren, ausgebildet sind, wobei die Füllpartikel dem Binder zugesetzt werden.

4. Verfahren zur Herstellung eines monolithischen Vielschichtaktors (1) aus einem piezokeramischen oder elektrostriktiven Material, wobei der Aktor als Stapelanordnung in quasi mechanischer Reihenschaltung einer Vielzahl von Piezoplatten (2) durch Sintern von Grünfolien ausgebildet wird, vorhandene Innenelektroden (3;4) im Plattenstapel zu gegenüberliegenden Aussenflächen des Stapels geführt und dort mittels Grundmetallisierung (5) sowie Aussenkontaktierung (12) jeweiliger Elektrodengruppen parallel verschalten sind,
**dadurch gekennzeichnet, dass**
entlang der Stapellängsachse im wesentlichen parallel zu den Innenelektroden (3;4), von diesen beabstandet, im Bereich der mindestens zwei gegenüberliegenden Aussenflächen, zu denen die Innenelektroden (3;4) herausgeführt sind, gezielt Gefügeschwächungen, die als Rissquelle (7) wirken, im Aktorgefüge mit einem Abstand im Bereich von 1 - 4 mm eingebaut werden, und weiterhin die Grundmetallisierung (5) und/oder die Aussenkontaktierung (12) mindestens im Bereich der Rissquellen (7) im Aktorgefüge dehnungsresistent oder elastisch ausgebildet ist, wobei
die Rissquellen (7) örtlich begrenzt ein Zusammensintern der Grünfolien verhindern und
die Rissquellen (7) durch Kerbanrisse induziert sind, welche entweder im grünen oder gesinterten Zustand erzeugt werden, jedoch ohne die tragende Querschnittsfläche des Aktorstapels zu reduzieren.

5. Verfahren nach einem der vorangegangen Ansprüche,
**dadurch gekennzeichnet, dass**
die Aussenkontaktierung (12) in Kenntnis der Lage der eingebrachten oder vorgesehenen Rissquellen (7) erstellt wird, wobei die Aussenkontaktierung (12) jeweils eine flächige Biegegelenkelektrode umfasst, welche mit der Grundmetallisierung mindestens im Bereich zwischen den Mikrostörungen punktuell oder abschnittsweise elektrisch in Verbindung steht.

6. Verfahren nach Anspruch 5,
**dadurch gekennzeichnet, dass**
die Biegeelektrode aus einem aufgelöteten Kupfer/Beryllium-Streifen besteht und der Streifen jeweils offene Ellipsenform (13) aufweisende Abschnitte umfasst, wobei die Hauptachse der jeweiligen offenen Ellipse (13) jeweils im Bereich einer der Rissquellen verläuft.

7. Verfahren nach Anspruch 5,
**dadurch gekennzeichnet, dass**
die Biegeelektrode als Mäander-oder Doppelmäanderelektrode ausgeführt ist, wobei die Verbindungsabschnitte des Mäanders jeweils im Bereich der Rissquellen (7) verlaufen.

8. Verfahren nach einem der Ansprüche 5 bis 7,
**dadurch gekennzeichnet, dass**
auf den Biegeelektroden Lötabschnitte oder Lötpunkte (11) zur weiteren Verdrahtung vorgesehen sind.

9. Verfahren nach einem der vorangegangen Ansprüche,
**dadurch gekennzeichnet, dass**
auf die Stapelanordnung elektrodenfreie passive Endschichten (14) als Kraftkoppelflächen aufgebracht werden.

10. Verfahren nach Anspruch 9,
**dadurch gekennzeichnet, dass**
der Abstand der ersten Rissquelle (7) zur passiven Endschicht (14) gleich dem ganzen oder halben Abstand der übrigen über die Längsachse verteilten Rissquellen (7) gewählt wird.

11. Monolithischer Vielschichtaktor (1) aus einem piezokeramischen oder elektrostriktiven Material, wobei der Aktor (1) eine Stapelanordnung von Piezoplatten ist, welche über innere Elektroden, eine gemeinsame Grundmetallisierung sowie Aussenkontaktierung (12) verfügt, hergestellt nach mindestens einem der Ansprüche 1 bis 10.

## Claims

1. A method for the production of a monolithic multilayer actuator (1) made of a piezoceramic or electrostrictive material, wherein the actuator is formed as a stacked arrangement in basically mechanical series connection of a plurality of piezo plates (2) by sintering of green sheets, existing inner electrodes (3; 4) in the plate stack are guided to opposite outer surfaces of the stack, and are switched in parallel there by means of basic metallization (5) and exterior contacting (12) of respective electrode groups, **characterized in that** weakenings in the structure, which act as microdisturbances (7), are incorporated in a specific manner into the actuator structure at a distance in the range of 1 to 4 mm along the longitudinal axis of the stack thereof, essentially parallel to and at a distance from the inner electrodes (3; 4) in the region of the at least two opposite outer surfaces to which the inner electrodes (3; 4) are brought out, and furthermore the basic metallisation (5) and/or the exterior contacting (12) is formed in a tensileresistant or elastic manner at least in the area of the microdisturbances (7) in the actuator structure, wherein the microdisturbances (7) prevent sintering together of the green sheets in a locally restricted manner and in the region of the microdisturbances (7) a layer or a quantity of an organic binder is applied during the stack build-up which contains a volume proportion of up to 50% of organic particles with a diameter ≤ 200 nm, which burn out nearly completely during the sintering process.

2. A method according to claim 1, **characterized in that** the layer is applied by screen printing, wherein said layer is compressed prior to the sintering by pressing in such a way that the ceramic particles embedded in the green sheets either touch each other only in part or not at all so as to specifically prevent sintering together in part or in full.

3. A method for the production of a monolithic multilayer actuator (1) made of a piezoceramic or electrostrictive material, wherein the actuator is formed as a stacked arrangement in basically mechanical series connection of a plurality of piezo plates (2) by sintering of green sheets, existing inner electrodes (3; 4) in the plate stack are guided to opposite outer surfaces of the stack, and are switched in parallel there by means of basic metallization (5) and exterior contacting (12) of respective electrode groups, **characterized in that** weakenings in the structure, which act as microdisturbances (7), are incorporated in a specific manner into the actuator structure at a distance in the range of 1 to 4 mm along the longitudinal axis of the stack thereof, essentially parallel to and at a distance from the inner electrodes (3; 4) in the region of the at least two opposite outer surfaces to which the inner electrodes (3; 4) are brought out, and furthermore the basic metallisation (5) and/or the exterior contacting (12) is formed in a tensileresistant or elastic manner at least in the area of the microdisturbances (7) in the actuator structure, wherein the microdisturbances (7) prevent sintering together of the green sheets in a locally restricted manner and the microdisturbances (7) are formed by a quantity of inorganic filling particles with a diameter of ≤ 1 µm, which do not react with the piezoelectric material of the stack, wherein the filling particles are added to the binder.

4. A method for the production of a monolithic multilayer actuator (1) made of a piezoceramic or electrostrictive material, wherein the actuator is formed as a stacked arrangement in basically mechanical series connection of a plurality of piezo plates (2) by sintering of green sheets, existing inner electrodes (3; 4) in the plate stack are guided to opposite outer surfaces of the stack, and are switched in parallel there by means of basic metallization (5) and exterior contacting (12) of respective electrode groups, **characterized in that** weakenings in the structure, which act as microdisturbances (7), are incorporated in a specific manner into the actuator structure at a distance in the range of 1 to 4 mm along the longitudinal axis of the stack thereof, essentially parallel to and at a distance from the inner electrodes (3; 4) in the region of the at least two opposite outer surfaces to which the inner electrodes (3; 4) are brought out, and furthermore the basic metallisation (5) and/or the exterior contacting (12) is formed in a tensileresistant or elastic manner at least in the area of the microdisturbances (7) in the actuator structure, wherein the microdisturbances (7) prevent sintering together of the green sheets in a locally restricted manner and the microdisturbances (7) are formed by notch cracks, which are either produced in the green or sintered state, but without reducing the carrying cross sectional surface of the actuator stack.

5. A method according to one of the preceding claims, **characterized in that** the exterior contacting (12) is produced with knowledge of the position of the introduced or provided microdisturbances (7), wherein the exterior contacting (12) respectively comprises a flat bending joint electrode, which is electrically in connection with the basic metallisation at least in the region between the microdisturbances in a punctiform manner or in sections.

6. A method according to claim 5, **characterized in that** the bending electrode consists of a soldered copper/beryllium strip, and the strip respectively comprises sections having open elliptical form (13), wherein the main axis of the respectively open ellipse (13) respectively extends in the region of one of the microdisturbances.

7. A method according to claim 5, **characterized in that** the bending electrode is formed as a meandering or double-meandering electrode, wherein the connecting sections of the meander respectively extend in the region of the microdisturbances (7).

8. A method according to one of the claims 5 to 7, **characterized in that** solder sections or solder points (11) for further wiring are provided on the bending electrodes.

9. A method according to one of the preceding claims, **characterized in that** electrode-free passive end layers (14) are applied to the stacked arrangement as force coupling surfaces.

10. A method according to claim 9, **characterized in that** the distance of the first microdisturbance (7) from the passive end layer (14) is selected equal to the entire or half distance of the remaining microdisturbances (7) which are distributed over the longitudinal axis.

11. A monolithic multilayer actuator (1) made from a piezoceramic or electrostrictive material, wherein the actuator (1) is a stacked arrangement of piezo plates which comprise inner electrodes, a common basic metallisation and exterior contacting (12), produced according to at least one of the claims 1 to 10.

## Revendications

1. Procédé de production d'un actionneur multicouche monolithique (1) à partir d'un matériau piézocéramique ou électrostrictif, dans lequel on réalise l'actionneur en tant qu'empilement monté en rangée quasiment mécanique d'une multitude de plaques piézoélectriques (2) par frittage de feuilles crues, on amène des électrodes intérieures existantes (3 ; 4) dans l'empilement de plaques jusqu'à des surfaces extérieures opposées de l'empilement et on les connecte ici en parallèle au moyen d'une métallisation de base (5) et d'un contact extérieur (12) de groupes d'électrodes respectifs,
**caractérisé en ce que**
le long d'un axe longitudinal de l'empilement, sensiblement parallèlement aux électrodes intérieures (3 ; 4) et à distance de celles-ci, dans la zone desdites au moins deux surfaces extérieures opposées auxquelles sont amenées les électrodes intérieures (3 ; 4), on intègre de façon ciblée des affaiblissements structurels faisant office de source de fissuration (7) dans la structure de l'actionneur à une distance dans l'ordre de 1 - 4 mm, et on réalise en outre la métallisation de base (5) et/ou le contact extérieur (12) de façon résistante à la dilatation ou de façon élastique au moins dans la zone des sources de fissuration (7) dans la structure de l'actionneur,
dans lequel les sources de fissuration (7) empêchent de façon localement limitée une agglomération par frittage des feuilles crues, et une couche ou une quantité d'un liant organique est déposée dans la zone des sources de fissuration (7) dans l'empilement, qui contient une proportion volumique allant jusqu'à 50 % de particules organiques d'un diamètre ≤ 200 nm qui sont consommées pratiquement complètement lors du processus de frittage.

2. Procédé selon la revendication 1,
**caractérisé en ce que**
l'on dépose la couche par sérigraphie, cette couche étant compactée par pressage avant le frittage, de telle sorte que les particules céramiques noyées dans les feuilles crues ne se touchent pas ou que partiellement, afin d'empêcher complètement ou en partie et de façon ciblée une agglomération par frittage.

3. Procédé de production d'un actionneur multicouche monolithique (1) à partir d'un matériau piézocéramique ou électrostrictif, dans lequel on réalise l'actionneur en tant qu'empilement monté en rangée quasiment mécanique d'une multitude de plaques piézoélectriques (2) par frittage de feuilles crues, on amène des électrodes intérieures existantes (3 ; 4) dans l'empilement de plaques jusqu'à des surfaces extérieures opposées de l'empilement et on les connecte ici en parallèle au moyen d'une métallisation de base (5) et d'un contact extérieur (12) de groupes d'électrodes respectifs,
**caractérisé en ce que**
le long d'un axe longitudinal de l'empilement, sensiblement parallèlement aux électrodes intérieures (3 ; 4) et à distance de celles-ci, dans la zone desdites au moins deux surfaces extérieures opposées auxquelles sont amenées les électrodes intérieures (3 ; 4), on intègre de façon ciblée des affaiblissements structurels faisant office de source de fissuration (7) dans la structure de l'actionneur à une distance dans l'ordre de 1 - 4 mm, et on réalise en outre la métallisation de base (5) et/ou le contact extérieur (12) de façon résistante à la dilatation ou de façon élastique au moins dans la zone des sources de fissuration (7) dans la structure de l'actionneur,
dans lequel les sources de fissuration (7) empêchent de façon localement limitée une agglomération par frittage des feuilles crues, et on réalise les sources de fissuration (7) par une quantité de particules de charge inorganiques d'un diamètre ≤ 1 µm qui ne réagissent pas avec le matériau piézoélectrique de l'empilement, les particules de charge étant ajoutées au liant.

4. Procédé de production d'un actionneur multicouche monolithique (1) à partir d'un matériau piézocéramique ou électrostrictif, dans lequel on réalise l'actionneur en tant qu'empilement monté en rangée quasiment mécanique d'une multitude de plaques piézoélectriques (2) par frittage de feuilles crues, on amène des électrodes intérieures existantes (3 ; 4) dans l'empilement de plaques jusqu'à des surfaces extérieures opposées de l'empilement et on les connecte ici en parallèle au moyen d'une métallisation de base (5) et d'un contact extérieur (12) de groupes d'électrodes respectifs,
**caractérisé en ce que**
le long d'un axe longitudinal de l'empilement, sensiblement parallèlement aux électrodes intérieures (3 ; 4) et à distance de celles-ci, dans la zone desdites au moins deux surfaces extérieures opposées auxquelles sont amenées les électrodes intérieures (3 ; 4), on intègre de façon ciblée des affaiblissements structurels faisant office de source de fissuration (7) dans la structure de l'actionneur à une distance dans l'ordre de 1 - 4 mm, et on réalise en outre la métallisation de base (5) et/ou le contact extérieur (12) de façon résistante à la dilatation ou élastique au moins dans la zone des sources de fissuration (7) dans la structure de l'actionneur,
dans lequel les sources de fissuration (7) empêchent de façon localement limitée une agglomération par frittage des feuilles crues, et on induit les sources de fissuration (7) par des amorces d'encoche que l'on ménage soit dans l'état cru soit dans l'état fritté, cependant sans réduire la surface de section transversale porteuse de l'empilement de l'actionneur.

5. Procédé selon l'une des revendications précédentes,
**caractérisé en ce que**
on réalise le contact extérieur (12) en connaissant la position des sources de fissuration (7) ménagées ou prévues, le contact extérieur (12) comprenant une électrode surfacique flexible qui est en connexion électrique ponctuellement ou localement avec la métallisation de base au moins dans la zone entre les micro-perturbations.

6. Procédé selon la revendication 5,
**caractérisé en ce que**
l'électrode flexible est constituée d'une bande de cuivre/béryllium rapportée par brasage et **en ce que** la bande comprend des portions présentant chacune une forme elliptique ouverte (13), l'axe principal de la forme elliptique ouverte respective (13) s'étendant dans la zone de l'une des sources de fissuration.

7. Procédé selon la revendication 5,
**caractérisé en ce que**
l'électrode flexible est réalisée sous forme d'électrode en méandre ou en méandre double, les portions de liaison du méandre s'étendant respectivement dans la zone des sources de fissuration (7).

8. Procédé selon l'une des revendications 5 à 7,
**caractérisé en ce que**
sur les électrodes flexibles sont prévu(e)s des portions de brasage ou des points de brasage (11) pour la suite du câblage.

9. Procédé selon l'une des revendications précédentes,
**caractérisé en ce que**
l'on dépose sur l'empilement des couches d'extrémité passives (14) exemptes d'électrode à titre de surfaces de couplage de force.

10. Procédé selon la revendication 9,
**caractérisé en ce que**
la distance de la première source de fissuration (7) à la couche d'extrémité passive (14) est choisie égale à la totalité ou à la moitié de la distance des autres sources de fissuration (7) réparties sur l'axe longitudinal.

11. Actionneur multicouche monolithique (1) d'un matériau piézocéramique ou électrostrictif, dans lequel l'actionneur (1) est un empilement de plaques piézoélectriques, qui dispose d'électrodes intérieures, d'une métallisation de base commune ainsi que d'un contact extérieur (12), réalisé selon l'une au moins des revendications 1 à 10.
